## Europäisches Patentamt
## European Patent Office
## Office européen des brevets

(19)

(11) Veröffentlichungsnummer: **0 261 366**

**A1**

(12) # EUROPÄISCHE PATENTANMELDUNG

(21) Anmeldenummer: **87111421.1**

(22) Anmeldetag: **07.08.87**

(51) Int. Cl.4: **H03F 3/217**

(30) Priorität: **26.09.86 DE 3632716**

(43) Veröffentlichungstag der Anmeldung:
**30.03.88 Patentblatt 88/13**

(84) Benannte Vertragsstaaten:
**CH DE FR GB LI**

(71) Anmelder: **Licentia Patent-Verwaltungs-GmbH**
**Theodor-Stern-Kai 1**
**D-6000 Frankfurt/Main 70(DE)**

(72) Erfinder: **Lodahl, Manfred, Dipl.-Ing.**
**Spindelmühler Weg 6**
**D-1000 Berlin 45(DE)**

(74) Vertreter: **Schulze, Harald Rudolf, Dipl.-Ing. et al**
**Licentia Patent-Verwaltungs-GmbH**
**Theodor-Stern-Kai 1**
**D-6000 Frankfurt/Main 70(DE)**

(54) **Schneller digitaler Leistungsverstärker.**

(57) Die Erfindung betrifft einen Schaltverstärker, der insbesondere als digitaler Leistungsverstärker für die Endstufe eines AM-Rundfunksenders geeignet ist. Dabei werden Teilspannungsquellen in Reihe geschaltet, so daß eine schaltbare variable Ausgangsgleichspannung herstellbar ist, die z. B. einem zu verstärkenden NF-Signal entspricht. Mindestens eine der Teilspannungsquellen enthält eine Schaltergruppe, die vorteilhafterweise aus mehreren parallel geschalteten (Leistungs-)Halbleiterschaltern besteht. Dadurch ist es möglich, die bei den Schaltvorgängen entstehende störende Verlustleistung derart auf die Halbleiterschalter zu verteilen, daß deren Zerstörung vermieden wird. Durch Spitzenstrombegrenzer erfolgt eine Limitierung der durch die Freilaufdioden gegebenen Kommutierungsströme.

FIG.1

## Schneller digitaler Leistungsverstärker

Die Erfindung betrifft einen schnellen digitalen Leistungsverstärker nach dem Oberbegriff des Patentanspruchs 1.

Ein solcher Leistungsverstärker ist beispielsweise als Modulationsverstärker bei einem amplitudenmodulierten (AM-)Rundfunksender einsetzbar.

Als Modulationsverstärker für AM-Rundfunksender sind Modulationsverstärker geeignet, die gleich-und niederfrequente Wechselspannung (NF-Spannung) verstärker können.

Eine vorteilhafte Schaltung eines Digitalverstärkers besteht in einer Reihenschaltung von einzelnen getrennt steuerbaren Spannungsquellen mit binärer Wichtung, wie sie aus der deutschen Offenlegungsschrift DE 30 44 956 A1 her bekannt ist. Um ein verzerrungsarmes Ausgangssignal zu gewinnen, ist eine hohe Schaltfrequenz erforderlich und zur Eliminierung unerwünschter Spektralkomponenten am Ausgang des Verstärkers ein der Reihenschaltung von Spannungsquellen nachgeschaltetes Tiefpaßfilter.

Der in der DE 30 44 956 A1 angegebene Verstärker hat den Nachteil, daß er als Leistungsverstärker für den angegebenen Verwendungszweck ungeeignet ist, da das Ein-und Ausschalten der Halbleiterschalter der einzelnen Spannungsquellen mit einer von den Qualitätsanforderungen an Rundfunksendern her vorgegebenen hohen Schaltfrequenz nicht durchführbar ist. Die hohen Schaltverluste, insbesondere unter Berücksichtigung der durch die Freilaufdioden gegebenen Kommutierungsströme, würden zu einer Zerströung der Halbleiterschalter führen.

Bei AM-Rundfunksendern beträgt die niederfrequente Übertragungsbandbreite derzeit im allgemeinen ca. 5 kHz. Zur Vermeidung störender Aussendungen des Rundfunksenders infolge digitaler Schaltvorgänge bei dem Modulationsverstärker, muß dem Modulationsverstärker ein Tiefpaßfilter nachgeschaltet werden, dessen Grenzfrequenz oberhalb der höchsten zu übertragenden Niederfrequenz und unterhalb der Schaltfrequenz liegt. Je höher die Schaltfrequenz liegt, desto einfacher und daher kostengünstiger kann das Tiefpaßfilter ausgeführt werden, jedoch steigen mit höherer Schaltfrequenz die Schaltverluste des Verstärkers. Wählt man kompromißweise für die Grenzfrequenz des Tiefpaßfilter $f_g$ = 20 kHz und für die Schaltfrequenz $f_s$ = 80 kHz, so bedeutet dies für die - schaltbaren Spannungsquellen einer Binärstufenanordnung eine maximale Schaltfrequenz von

$$\frac{f_s}{2} = 40 \text{ kHz.}$$

Dies ist für Leistungshalbleiterschalter ein zu hoher Wert. Leistungshalbleiterschalter für eine Schaltfrequenz von 10 kHz sind hingegen relativ leicht zu realisieren und daher kostengünstig herstellbar.

Der Erfindung liegt die Aufgabe zugrunde, einen gattungsgemäßen Schaltverstärker dahingehend zu verbessern, daß die (Teil-)Spannungsquellen einerseits mit einer hohen Schaltfrequenz schaltbar sind und andererseits an den zugehörigen Schaltern ein Überschreiten einer vorgebbaren elektrischen Verlustleistung vermieden wird.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Ein Vorteil der Erfindung besteht darin, daß trotz einer vorteilhaft hohen Schaltfrequenz, mit welcher die Teilspannungsquellen betrieben werden, die zugehörigen Halbleiterschalter mit einer derart niedrigen Schaltfrequenz ansteuerbar sind, daß eine in den Halbleiterschaltern entstehende elektrische Verlustleistung bestimmte zulässige Werte nicht überschreitet.

Die Erfindung wird im folgenden anhand eines Ausführungsbeispiels' näher erläutert unter Bezugnahme auf eine schematische Zeichnung.

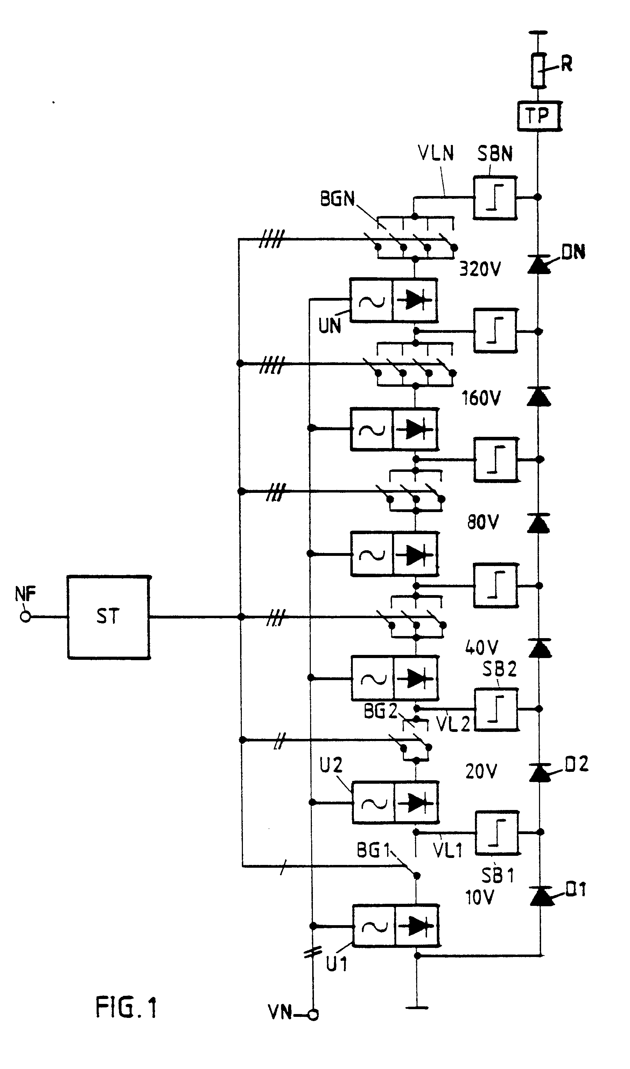

Die Figur 1 zeigt das Blockschaltbild einer beispielhaften Schaltungsanordnung, die aus sechs in Reihe schaltbaren Teilspannungsquellen U1 bis UN (N = 6) besteht. Jede Teilspannungsquelle wird aus dem Versorgungsnetz VN, z. B. 220 V, 50 Hz, über eine Zweidrahtleitung gespeist und enthält eine Gleichrichteranordnung. Die jeweils erzeugten Gleichspannungen sind ausgehend von einem minimalen Feinstufenwert von z.B. $U_{min}$ = 10 V binär gewichtet und betragen entsprechend der dargestellten Zahlenreihe 10 V bis 320 V. Diese Teilgleichspannungen sind über eine Diodenkaskade D1 bis DN addierbar, so daß an dem Verstärkerausgang eine maximale Gleichspannung von 630 V, in minimalen Stufen von 10 V, erzeugbar ist. Die Verbindungsleitungen VL1 bis VLN zwischen den Teilspannungsquellen U1 bis UN und den zugehörigen Dioden der Diodenkaskade D1 bis DN enthalten jeweils einen Spitzenstrombegrenzer SB1 bis SBN, der im wesentlichen entstehende störende Kommutierungsstromspitzen auf eine nicht störende maximale Stromstärke begrenzt.

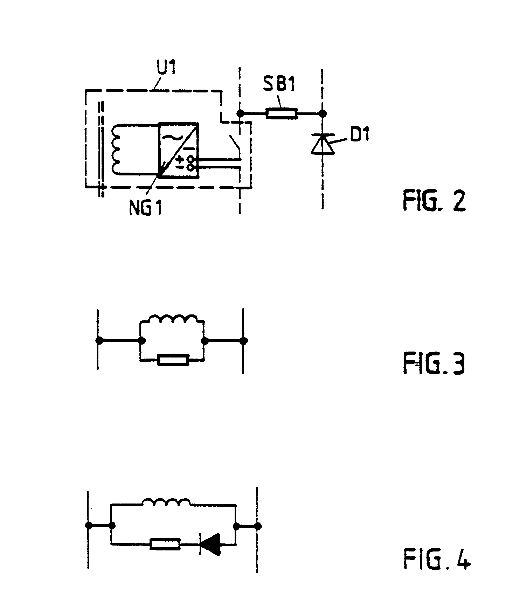

In Fig. 2 ist ein beispielhafter Aufbau einer der Teilspannungsquellen U1 bis UN gezeigt. Die angegebene Schalteranordnung ist eine steuerbare Halbieterschaltung. Als Halbleiter sind z.B. Leistungstransistoren, Feldeffekttransistoren Thyristoren oder GTO's geeignet. Die beispielhaft gewählte Teilspannungsquelle U1 besitzt eine zugehörige Freilaufdiode D1, über die im Falle des gesperrten Halbleiterschalters der Strom des Schaltverstärkers fließt. Wenn sämtliche Teilspannungsquellen U1 bis UN ausgeschaltet sind, fließt kein Strom mehr. Mit NG1 ist ein vorzugsweise dreiphasiger Gleichrichter bezeichnet.

Durch die Spitzenstrombegrenzer SB1 bis SBN (Fig. 1) wird die im wesentlichen durch den Kommutierungsstrom der Freilaufdiode bedingte Stromspitze beim Einschalten der Schalteranordnungen begrenzt, wodurch bedeutend höhere Betriebsströme für die Teilspannungsquellen U1 bis UN möglich sind. Eine solche Einrichtung ist besonders vorteilhaft bei Teilspannungsquellen, die als Schalteranordnung Feldeffekttransistoren benutzen. In Fig. 2 besteht der Spitzenstrombegrenzer SB1 im einfachsten Fall aus einem ohmschen Widerstand. Ein anderes Ausführungsbeispiel für einen Spitzenstrombegrenzer ist eine Parallelschaltung von Widerstand und Spule (Fig. 3), wobei alternativ hierzu in einem oder in beiden Parallelkreisen in Reihe zu Widerstand und Spule noch eine Diode vorgesehen werden kann (Fig. 4).

Der Strombegrenzer ist zwischen dem Ausgang der Schalteranordnung und dem Ausgang der Freilaufdiode angeordnet.

Bei jeder Teilspannungsquelle U1 bis UN ist jeweils die Gleichrichteranordnung in Reihe geschaltet mit einer Schaltergruppe BG1 bis BGN, so daß die jeweils erzeugte Gleichspannung schaltbar ist. Mindestens eine der Schaltergruppen BG1 bis BGN wird von getrennt steuerbaren, parallel geschalteten Halbleiterschaltern gebildet. Die Anzahl der jeweils parallel zu schaltenden Halbleiterschalter wird aus dem Verhältnis von Schaltfrequenz einer Schaltergruppe zur maximal zulässigen Schaltfrequenz der Halbleiterschalter bestimmt. Die Zahl der parallel geschalteten Halbleiterschalter in den einzelnen Schaltergruppen kann dabei unterschiedlich sein. So könnten z. B. in allen Gruppen mit kleineren binären Spannungswerten, wegen der geringeren Schaltverluste und der Verfügbarkeit schnellerer Halbleiterschalter für kleinere Spannungen, weniger Halbleiterschalter parallel geschaltet werden als bei den Schaltergruppen mit hohen Spannungswerten. Die Steuerung der einzelnen Halbleiterschalter in den verschiedenen Schaltergruppen wird von einer Steuereinheit ST durchgeführt, an deren Eingang das NF-Signal oder ein dementsprechendes Signal anliegt und von deren Ausgang mehradrige Steuerleitungen zu den Schaltergruppen führen.

Eine möglichst gleichmäßige zeitliche Verteilung der Verlustleistung der Halbleiterschalter wird dadurch erreicht, daß die parallel geschalteten Halbleiterschalter der Reihe nach ein-und ausgeschaltet werden und die jeweils am längsten nicht beanspruchten Halbleiterschalter der Schaltergruppen wieder zuerst eingeschaltet werden. Damit wird nicht nur eine optimale zeitliche Verteilung der Schaltverluste auf die einzelnen Halbleiterschalter erreicht, sondern gleichzeitig das für Halbleiterschalter in Schaltungsanordnungen mit Freilaufdioden wegen deren hohen Kommutierungsströme nachteilige sofortige Wiedereinschalten eines gerade ausgeschalteten Halbleiterschalters vermieden.

## Ansprüche

1. Schneller digitaler Leistungsverstärker, insbesondere zur Erzeugung einer amplitudenmodulierten Anodenspannung für einen AM-Rundfunksender, bestehend aus
-einer ersten Reihenschaltung von mehreren - schaltbaren Teilspannungsquellen (U1 bis UN),
-mehreren Freilaufdioden (D1 bis DN), deren Anzahl zumindest derjenigen der Teilspannungsquellen (U1 bis UN) entspricht, in einer zweiten Reihenschaltung, an deren Ausgängen eine Last (R) anschließbar ist,
-mehreren Verbindungsleitungen (VL1 bis VLN), die jeweils einen Verknüpfungspunkt der Teilspannungsquellen (U1 bis UN) mit einem zugehörigen Verknüpfungspunkt der Freilaufdioden (D1 bis DN) verbinden, und
-einer Steuereinheit (ST), welche die Teilspannungsquel len (U1 bis UN) schaltet nach Maßgabe eines zu verstärkenden Niederfrequenz-Signals (NF), das am Eingang der Steuereinheit (ST) anliegt, dadurch gekennzeichnet,
-daß zumindest eine Teilspannungsquelle (U2), die durch das Niederfrequenz-Signal (NF) ansteuerbar ist, durch eine Schaltergruppe (BG2) schaltbar ist,
-daß die Schaltergruppe (BG2)aus mindestens zwei parallel geschalteten Halbleiterschaltern besteht,
-daß die Halbleiterschalter unabhängig voneinander ein-sowie ausschaltbar sind,
-daß für einen ersten Schaltvorgang lediglich eine Teilzahl der Halbleiterschalter benutzt wird und
-daß für einen zeitlich nachfolgenden zweiten Schaltvorgang mindestens ein Halbleiterschalter benutzt wird, der bei dem ersten Schaltvorgang unbenutzt geblieben ist oder lediglich mit einer geringen Verlustleistung beaufschlagt worden ist.

2. Schneller digitaler Leistungsverstärker nach Anspruch 1, dadurch gekennzeichnet, daß die in einer Schaltergruppe vorhandene Anzahl der Halbleiterschalter in Abhängigkeit von der zulässigen Verlustleistung und von der maximal zulässigen Schaltfrequenz eines einzelnen Halbleiterschalters gewählt ist.

3. Schneller digitaler Leistungsverstärker nach Anspruch 1 oder Anspruch 2, dadurch gekennzeichnet, daß die Halbleiterschalter innerhalb einer Schaltergruppe nacheinander ein-und ausgechaltet werden und daß innerhalb der Schaltgruppen die Wiedereinschaltung jeweils der Halbleiterschalerfolgt, welche die längste Zeit ausgeschaltet oder am geringsten verlustleistungsmäßig beansprucht waren.

4. Schneller digitaler Leistungsverstärker nach einem der vorhergehenden Ansprüche, dadurch gekennzeichnet, daß zur Begrenzung von Kommutierungsstromspitzen Spitzenstrombegrenzer vorgesehen sind.

FIG. 1

FIG. 2

FIG.3

FIG. 4

Europäisches
Patentamt

**EUROPÄISCHER RECHERCHENBERICHT**

Nummer der Anmeldung

EP 87 11 1421

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 083 727 (HARRIS CORP.)<br>* Figuren 1-4,8,9; Seite 15, Zeile 23 - Seite 20, Zeile 13; Seite 33, Zeile 17 - Seite 35, Zeile 3 *<br>--- | 1 | H 03 F 3/217 |
| A | EP-A-0 058 443 (BBC AG)<br>* Figur 3; Seite 5, Zeilen 6-11; Seite 10, Zeilen 3-18 *<br>--- | 1-3 | |
| A | EP-A-0 124 765 (BBC AG)<br>* Figuren 1-3; Zusammenfassung; Seite 5, Zeile 15 - Seite 11, Zeile 11 *<br>--- | 1 | |
| P,X | EP-A-0 218 152 (LICENTIA)<br>* Figuren 1,2,7,12; Spalte 15, Zeile 6 - Spalte 16, Zeile 18; Patentansprüche 11-16 *<br>----- | 1-4 | |

RECHERCHIERTE SACHGEBIETE (Int. Cl.4)

H 03 F

Der vorliegende Recherchenbericht wurde für alle Patentansprüche erstellt

| Recherchenort | Abschlußdatum der Recherche | Prüfer |
|---|---|---|
| DEN HAAG | 09-12-1987 | TYBERGHIEN G.M.P. |